# EUROPÄISCHE PATENTSCHRIFT

(11) **EP 0 854 666 B1**
(45) Veröffentlichungstag und Bekanntmachung des Hinweises auf die Patenterteilung: **26.11.2003**
(21) Anmeldenummer: 97116012.2
(22) Anmeldetag: 15.09.1997
(51) Int. Cl.: H05K 5/00, H05K 7/20

(54) **Steuergerät bestehend aus mindestens zwei Gehäuseteilen**
Control device comprising at least two housing parts
Appareil de commande dont le boîtier est fait de deux parties au moins

(30) Priorität: 20.01.1997 DE 19701731
(43) Veröffentlichungstag der Anmeldung: 22.07.1998
(73) Patentinhaber: ROBERT BOSCH GMBH, 70442 Stuttgart (DE)
(72) Erfinder: Lochbrunner, Eduard, 71282 Hemmingen (DE); Stroebele, Hans-Peter, 70195 Stuttgart (DE); Weber, Bernd, 74232 Abstatt (DE); Schmid, Roland, Dr., 72581 Dettingen (DE); Denner, Volkmar, Dr., 72793 Pfullingen (DE); Schweinbenz, Jochen, 70469 Stuttgart (DE); Schiefer, Peter, 74199 Untergruppenbach (DE); Eberlein, Edwin, 70197 Stuttgart (DE); Reihlen, Eckart, Dr., DK-9000 Aalborg (DK); Presser, Lothar, 38228 Salzgitter (DE); Paul, Katrin, 31199 Diekholzen (DE)

(56) Entgegenhaltungen:
- EP-A- 0 625 871
- WO-A-96/23397
- DE-A- 4 242 943
- US-A- 5 307 236

## Beschreibung

### Stand der Technik

Die Erfindung geht aus von einem Steuergerät bestehend aus mindestens zwei Gehäuseteilen nach der Gattung des unabhängigen Anspruchs. Bei einem aus der DE 40 09 445 A1 bekannten Steuergerät sind auf einer Leiterplatte mehrere Leistungsbauelemente angeordnet. Um die bei Betrieb auftretende hohe Verlustleistung dieser Leistungsbauelemente abzuleiten, sind auf der der Leiterplatte abgewandten Seite der Leistungsbauelemente Kühlkörper angeordnet. Diese Kühlkörper überdecken alle Leistungsbauelemente gemeinsam und weisen der Kontur der Leistungsbauelemente korrespondierende Vertiefungen auf, die den Konturen und den Höhen der Leistungsbauelemente folgen. Zusätzlich ist über die Leiterplatte und die Kühlelemente noch ein Gehäuseteil gestülpt. Durch die besondere Ausgestaltung der Kühlelemente baut das Steuergerät relativ aufwendig. Ferner ist auch keine direkte Abfuhr der Wärme durch eine Luftkonvektion möglich.

Aus der EP 625 871 ist bereits ein elektronisches Gerät mit einem Gehäuse, in dem eine Leiterplatte angeordnet ist, bekannt. Neben der Leiterplatte sind Leistungsbauelemente angeordnet, die mit Verbindungsdrähten mit der Leiterplatte verbunden sind. Die neben der Leiterplatte angeordneten Leistungsbauelemente werden zwischen zwei Gehäuseteilen eingepresst, wobei zwischen einem dieser Gehäuseteile und den Leistungsbauelementen noch eine Feder angeordnet ist, die zur Ausgleichung von Fertigung Toleranzen dient.

Aus der DE 42 42 943 ist eine Steuergerät bekannt, bei dem Leistungsbauelemente so in einem Randbereich einer Leiterplatte angeordnet sind, dass die zu kühlenden Flächen senkrecht zur Leiterplatte ausgebildet sind. Die zu kühlenden Flächen werden durch nach Innen ragenden Fortsetzen des Gehäuses gebildet, an denen die Leistungsbauelemente mit Klammern gepresst werden. Das Gehäuse muss daher diese besonders ausgebildeten Fortsetze enthalten.

### Vorteile der Erfindung

Das erfindungsgemäße Steuergerät mit den kennzeichnenden Merkmalen eines der beiden unabhängigen Ansprüche 1 oder 12 hat demgegenüber den Vorteil, daß ein relativ niedriger thermischer Widerstand erreicht wird, um die relativ hohe Verlustleistung der elektrischen Leistungsbauelemente abzuführen. Dadurch, daß das Gehäuse gleichzeitig als Kühlkörper dient und auf der der Leiterplatte abgewandten Seite der Leistungsbauelemente aufliegt, kann die Verlustwärme direkt nach außen abgeführt werden. Somit kann zusätzlich noch die außerhalb des Gehäuses wirkende Luftkonvektion zur Wärmeableitung einbezogen werden. Aufgrund der besseren Wärmeleitung kann die Besetzungsdichte der Leiterplatte mit Leistungsbauelementen und somit der Leistungsbereich des Steuergerätes erhöht werden. Die aufwendigen Konstruktionen mit einer Wärmeableitung durch die Leiterplatte hindurch kann entfallen. Die Leistungsbauelemente sind auf der Leiterplatte frei plazierbar und können in allen Lagen mit den Leiterbahnen verdrahtet werden. Die Leiterplatte selbst ist auf beiden Seiten bestückbar, wodurch ein Gewinn an Fläche entsteht, der zu einer Kostenersparnis führt. Auch können die Leistungsbauelemente nahe am Stecker angeordnet werden, wodurch nur relativ kurze elektrische Leitungen notwendig sind. Ferner sind die Leistungsbauelemente unter den Anforderungen einer relativ guten elektromagnetischen Verträglichkeit funktionsgerecht plazierbar. Das Steuergerät ist weiterhin auf den vorhandenen Fertigungstechniken weiterverarbeitbar. Die Messerleiste und die Steckmodule sind je nach den Anforderungen frei plazierbar. Dadurch ergibt sich eine erhöhte Flexibilität gegegenüber den Anforderungen der Kunden. Das Steuergerät selbst ist sehr kompakt, robust und kostengünstig herzustellen.

Mit Hilfe der in den Unteransprüchen erwähnten Federelementen, elastischen Bauteilen oder der in Gehäusebereichen eingebrachten Vorspannung kann die Auflage des Gehäuses auf der Oberseite des Leistungsbauelements verbessert und somit die Wärmeableitung erhöht werden.

Weitere Vorteile und vorteilhafte Weiterbildungen ergeben sich aus der Beschreibung und der Zeichnung.

### Zeichnung

Ausführungsbeispiele der Erfindung sind in der Zeichnung dargestellt und in der nachfolgenden Beschreibung näher erläutert. Die Figur 1 zeigt einen Schnitt durch eine schematische Darstellung eines Steuergeräts, Figuren 2 und 3 je einen Schnitt durch ein Steuergerät im Bereich des Steckers, die Figuren 4 und 5 jeweils einen Schnitt durch eine Abwandlung des Ausführungsbeispiels mit einer zusätzlichen Wärmeableitung, Figur 6 eine besondere Ausbildung der Leistungsbauelemente im Bereich des Steckers und die Figuren 7 bis 13 weitere Abwandlungen des Ausführungsbeispiels.

### Beschreibung der Ausführungsbeispiele

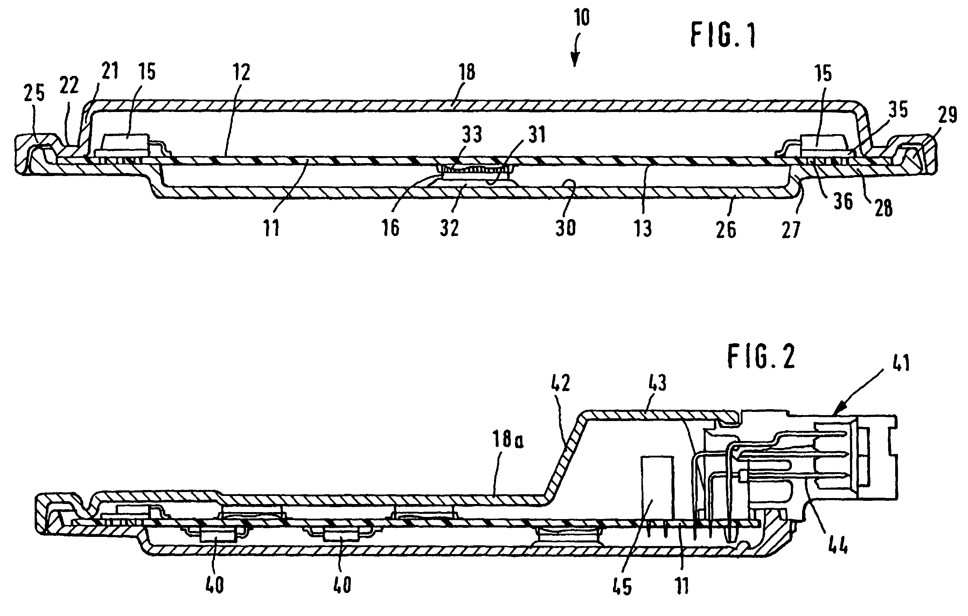

Das elektrische Schalt- oder Steuergerät 10 hat eine Leiterplatte 11, auf deren Oberseite 12 und auf deren Unterseite 13 eine elektronische Schaltung aufgebaut ist, von der nur einige elektronische Bauelemente 15, 16, die Verlustwärme bei Betrieb abgeben, dargestellt sind. In der Zeichnung sind diese Bauelemente 15, 16 als SMD-Bauelemente (Surface-Mounted-Device) ausgeführt. In nicht dargestellter Weise ist die Leiterplatte 11 in herkömmlicher Weise mit einer in der Figur 1 nicht dargestellten Steckerleiste verbunden.

Die Oberseite 12 der Leiterplatte 11 wird von einem wannenförmigen Gehäusedeckel 18 abgedeckt. Bis auf den Bereich der Steckerleiste hat der Gehäusedeckel 18 an seinen Gehäusewänden 21 eine umlaufende Sicke 22 deren Grund auf der Oberseite 12 der Leiterplatte 11 aufliegt. Die Gehäusewand 21 schließt mit einer entgegen der Richtung der Sicke 22 ausgebildeten zweiten Sicke 25 ab. Die Leiterplatte 11 kann dabei, wie oben erwähnt und in der Figur 1 dargestellt, bis unter den Boden der Sicke 22 reichen oder auch nur bis etwa zur Seitenwand 21. Die jeweilige Ausbildung ist zum Beispiel davon abhängig, wie weit der Rand der Leiterplatte 11 frei von Schaltungsbauteilen und Leiterbahnen zu halten ist.

Die Unterseite 13 der Leiterplatte 11 wird von einem ebenfalls wannenförmigen Gehäuseboden 26 umfaßt, dessen Seitenwände 27 einen durchgehenden, kragenförmigen Rand 28 haben, der mittel- oder unmittelbar auf dem äußeren Bereich der Unterseite 13 der Leiterplatte 11 anliegt. Der Rand 28 weist eine Umbördelung auf, mit der der Gehäuseboden 26 in die Sicke 23 des Gehäusedeckels 18 eingreift. Befestigt werden der Gehäusedeckel 18 und der Gehäuseboden 26 zum Beispiel mit mehreren an den Ecken des Gehäuses angeordneten, in der Figur nicht dargestellten Schrauben. Anstelle der erwähnten Verschraubungen können aber auch die Gehäuseteile durch Kleben, Löten, Bördeln, Nieten, mittels Rastelementen oder anderen Verbindungstechniken fest miteinander verbunden sein. Der Gehäusedeckel 18 und der Gehäuseboden 26 sind vorzugsweise aus einem gut wärmeleitenden Material, wie zum Beispiel Metalle (z.B. AL) gefertigt.

Der Gehäuseboden 26 liegt mit seiner Innenseite 30 auf der der Unterseite 13 der Leiterplatte 11 abgewandten Oberfläche 31 des Leistungsbauelements 16 an. Um eine einfache Montage zu ermöglichen, kann zwischen dem Leistungsbauelement 16 und dem Gehäuseboden 26 ein wärmeleitfähiger Haftvermittler 32, zum Beispiel ein Wärmeleitkleber oder eine beidseitig mit wärmeleitfähigen Material versehene Folie vorhanden sein. Muß das Leistungsbauelement 16 zum Gehäuseboden 26 hin isoliert sein, so kann der Haftvermittler diese Funktion übernehmen, indem er zum Beispiel aus einer elektrisch isolierende Eigenschaften aufweisenden Folie oder aus einem Kleber mit beigemischten Abstandshaltern besteht. Bei dieser Ausgestaltung ist es nicht notwendig, daß zwischen der Unterseite 13 der Leiterplatte und dem Leistungsbauelement 16 ein Bauteil aus wärmeleitfähigem Material sich befindet. Das Leistungsbauelement 16 ist mit Hilfe von mehreren Anschlüssen 33 mit den nicht dargestellten Leiterbahnen der Leiterplatte 11 verbunden.

Im Bereich des Rands 28 des Gehäusebodens 26 sind auf der Leiterplatte 11 die Leistungsbauelemente 15 in zum Beispiel aus der nachveröffentlichten DE-A1 19600619.8 bekannten Bauweise angeordnet. Die Leistungsbauelemente 15 sind mit Hilfe eines wärmeleitfähigen Elements 35 auf der Leiterplatte im Bereich des Rands 28 angeordnet. Unterhalb des wärmeleitfähigen Elements 35 sind in der Leiterplatte 11 mehrere Bohrungen ausgebildet. Bei diesen Leistungsbauelementen 15 muß die Verlustwärme über das notwendige wärmeleitfähige Element 35 und durch die Leiterplatte 11 hindurch zum Gehäuseboden 26 abgeführt werden.

Die Abwandlung des Ausführungsbeispiels nach der Figur 2 zeigt wie auf der Ober- 12 bzw. Unterseite 13 der Leiterplatte 11 Leistungsbauelemente 16 angeordnet sein können. Hierzu liegt auch der Gehäusedeckel 18 auf der Oberseite 31 an, die der Oberseite 12 der Leiterplatte 11 abgewandt ist. Ferner ist aus der Figur 2 ersichtlich, daß Leistungsbauelemente 40 mit geringerer Verlustwärme als die Leistungsbauelemente 16 weiterhin auf der Leiterplatte 11 angeordnet sein können und nicht zwangsläufig einen direkten Kontakt zur Gehäusewand aufweisen müssen. Ferner ist in der Figur 2 die Anbindung des Steckers 41 an das Steuergerät 10 dargestellt. Um den Stecker 41 seitlich am Steuergerät 10 anbringen zu können, weist der Deckel 18a eine Seitenwand 42 und einen mindestens über den Bereich des Steckers 41 ragenden Rand auf. Dadurch können die Pins 44 des Steckers 41 in das Innere des Steuergeräts 10 geführt werden und in einfacher Weise mit den Leiterbahnen der Leiterplatte 11 verbunden werden. Ferner können im Bereich des Steckers 41 aufgrund der größeren Bauhöhe des Deckels 18a auch höhere Bauelemente 45 auf der Leiterplatte 11 angeordnet werden.

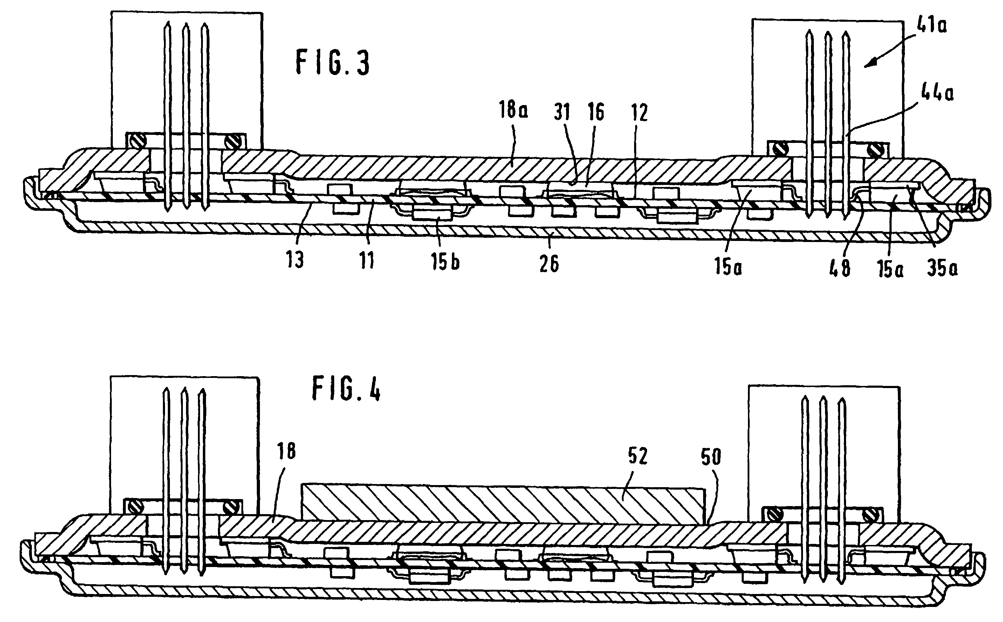

In der Abwandlung nach der Figur 3 sind auf einer Seite, d.h. auf der Unterseite 13 der Leiterplatte 11, Leistungsbauelemente 15b in herkömmlicher Bauweise, d.h. ohne direkten Kontakt mit einem Gehäuseteil 26, dargestellt. Auf der anderen Seite, d.h. auf der Oberseite 12 der Leiterplatte 11 sind die Leistungsbauelemente 16, wie in den Ausführungen nach der Figur 1 und 2 angeordnet, d.h. es besteht ein direkter Kontakt der Oberseite 31 des Leistungsbauelements 16 mit dem Gehäusedeckel 18a. Es können auch Leistungsbauelemente 15a so auf der Oberseite 12 der Leiterplatte 11 angeordnet sein, daß die Leistungsbauelemente 15a mit ihrer Oberseite auf der Leiterplatte aufliegen und mit dem wärmeableitenden Teil 35a am Gehäusedeckel 18a anliegen. Diese Bauweise ist besonders im Bereich der Stecker 41a vorteilhaft. Die Stecker 41a sind im Ausführungsbeispiel nach der Figur 3 senkrecht zur Leiterplatte 11 angeordnet.

Die Figuren 4 bis 6 zeigen Abwandlungen, bei denen mit Hilfe zusätzlicher Mittel die Wärmeableitung auf der Außenseite mindestens eines der Gehäuseteile, d.h. des Gehäusedeckels 18 oder des Gehäusebodens 26, verbessert wird. So kann in der Figur 4 auf der Außenseite 50 des Gehäusedeckels 18 zusätzlich eine Wärmesenke 52 angeordnet werden. Dadurch wird die Wärmeableitung im Bereich des Elements 52 verbessert. Das Element 52 kann hierbei als Block mit zum Beispiel in der Figur 4 mit rechteckigem Querschnitt ausgebildet sein.

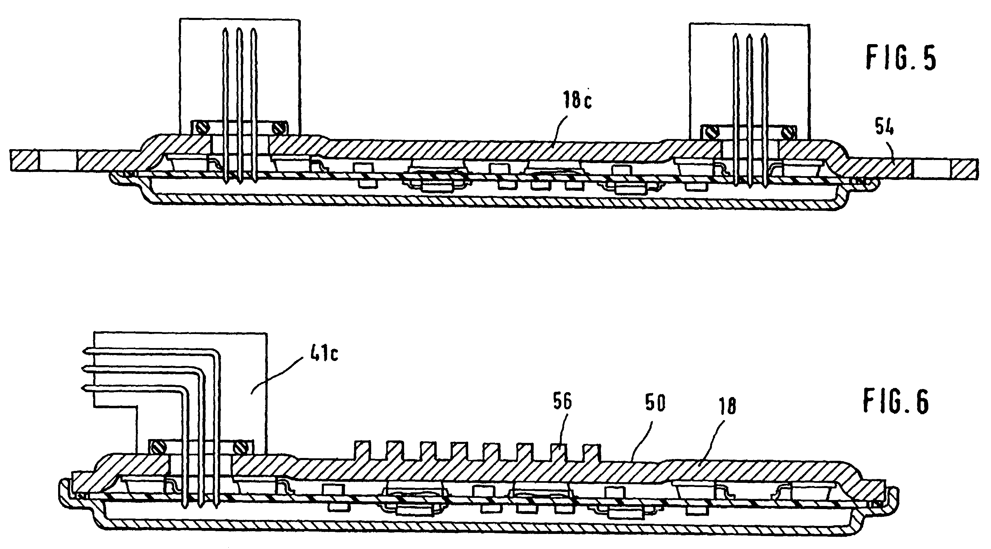

Entsprechend der Darstellung in der Figur 5 ist es zur zusätzlichen Wärmeableitung möglich, daß der Gehäusedeckel 18c Befestigungslaschen 54 aufweist, mit denen das Steuergerät 10 an einer Wärmesenke (z.B. Karosserieblech) befestigt ist. Dadurch wird mit Hilfe der Befestigungslaschen 54 die Wärme vom Gehäusedeckel 18c zur Befestigungsfläche abgeführt. Hierdurch entsteht ein thermischer Parallelpfad wo, zusätzlich Wärme abgegeben wird. Der Gehäusedeckel 18a kann gemeinsam mit den Befestigungslaschen 54 als ein Teil und zum Beispiel als Stanzbiegeblech kostengünstig hergestellt werden. Selbstverständlich kann die Befestigungslasche 54 auch am Gehäuseboden 26 ausgebildet sein. Ferner wäre es auch denkbar, die Befestigungslaschen 54 nur auf einer Seite auszubilden. Auch ist die Form der Befestigungslaschen in einfacher Weise der Flächenkontur des Anschraubbereichs anpaßbar.

In der Figur 6 wird mit Hilfe an der Außenwand 50 des Gehäusedeckels 18 angebrachten Kühlrippen 56 die Wärmeabfuhr durch Konvektion verbessert. Die Kühlrippen 56 ermöglichen eine zusätzliche Wärmeabgabefläche und eine gesteuerte Führung des Luftstroms, der sich am Gehäuse entlang bewegt. Selbstverständlich ist es auch möglich, die in den Figuren 4 bis 6 beschriebenen zusätzlichen Wärmeableitungsmaßnahmen untereinander zu kombinieren und somit eine optimale Wärmeabführung zu ermöglichen. Beim Ausführungsbeispiel nach der Figur 6 ist auch der Stecker 41c abgewinkelt ausgebildet und kann somit den Einbaumöglichkeiten angepaßt werden. Selbstverständlich ist es auch möglich, die in den Figuren 2 bis 6 dargestellten Stecker bei einem Ausführungsbeispiel untereinander zu kombinieren. Somit können bei verschiedenen Steckern bzw. bei mehreren Steckeranschlüssen verschiedene Funktionsgruppen auf der Leiterplatte zusammengefaßt werden und in eigenen Kontaktierungssystemen über einen eigenen Stecker mit dem jeweiligen Gerät verbunden werden.

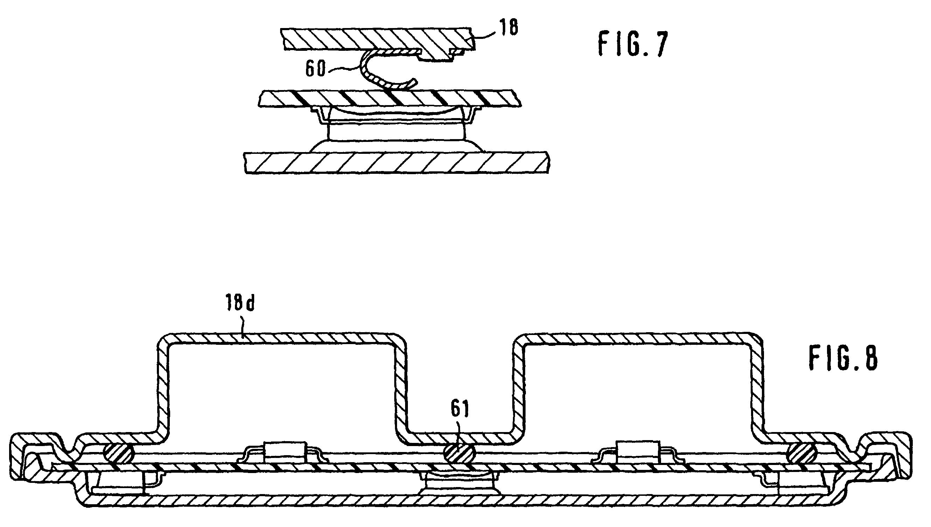

Um eine möglichst gute Wärmeableitung vom Leistungsbauelement 16 zum Gehäusedeckel 18 bzw. zum Gehäuseboden 26 zu erreichen, muß die Oberseite des Leistungsbauelements 16 möglichst großflächig und über die Auflagefläche möglichst gleichmäßig und möglichst vollständig am Gehäusedeckel bzw. am Gehäuseboden anliegen. Es soll dadurch ein niederer thermischer Übergangswiderstand zwischen dem Leistungsbauelement und den jeweiligen Gehäusebauteilen erreicht werden und somit ein, wenn auch geringer, thermischer Widerstand durch Luft oder nicht vollständige Kontaktierung der Flächen verhindert werden. Durch Verwendung zusätzlicher mechanischer Hilfsmittel wird in den Figuren 7 bis 11 eine Anpreßkraft aufgebracht, die das Leistungsbauelement 16 auf das Gehäuseteil bzw. in umgekehrter Form das Gehäuseteil auf das Leistungsbauelement aufdrückt. Diese mechanischen Hilfsmittel dienen auch zugleich als zusätzliche Fixierung der Leiterplatte. Der in den bisherigen Ausführungsbeispielen erwähnte Haftvermittler 32 zwischen dem Leistungsbauelement 16 und dem jeweiligen Gehäuseteil kann teilweise, abhängig von den Einsatzbedingungen beibehalten werden oder auch entfallen. Dieses zusätzliche Hilfsmittel kann auch das zur Vernetzung des Haftvermittlers während der Fertigung notwendige Niederhalteelement ersetzen, wodurch die Fertigung vereinfacht wird. In der Figur 7 wird nun mit Hilfe eines zusätzlichen Federelements 60 das Leistungsbauelement 16 auf die Innenseite eines der Gehäuseteile gedrückt. Die Anpreßkraft des Federelements kann hierbei direkt auf das betroffene Leistungsbauelement oder auf die Leiterplatte wirken. Das Federelement 60 liegt an der Innenseite des Gehäusedeckels 18 oder auch des Gehäusebodens 26 an. Das Federelement 60 kann zum Beispiel an der Innenseite des Gehäusedeckels 18 angenietet oder angeschraubt sein; ferner wäre auch eine formschlüssige Verbindung zwischen dem Gehäusedeckel und dem Federelement 60 denkbar. Andererseits liegt das Federelement 60 auf der dem Leistungsbauelement 16 abgewandten Seite der Leiterplatte 11 auf. Um eine einfache Montage zu ermöglichen, soll das Leistungsbauelement 16 möglichst nur mit wenigen, d.h. im optimalen Fall nur mit einem, Federelement 60 angedrückt werden. Um ferner eine gleichmäßige Verteilung der Anpreßkraft zu erreichen, sollte das Federelement 60 zentrisch auf dem Leistungsbauelement 16 aufliegen. Ist eine einzelne Anpressung von einem einzelnen Leistungsbauelement 16 angestrebt, so sollte das Federelement 60 etwa mittig auf dem Leistungsbauelement 16 aufliegen. Befinden sich aber mehrere Leistungsbauelemente 16 hintereinander in einer Linie angeordnet auf der Leiterplatte 11, so kann mit einem länglichen unterteilten Federelement gearbeitet werden, das etwa mittig über den Leistungsbauelementen zur Auflage kommt.

In der Figur 8 wird als Hilfsmittel zur Anpressung des Leistungsbauelements 16 ein elastisches Bauteil aus Kunststoff verwendet. In der Figur 8 ist dies als Elastomerstreifen 61 dargestellt. Dieser Elastomerstreifen 61 kann kreisförmigen, rechteckigen oder jeden anderen Querschnitt aufweisen, wodurch eine gleichmäßige Anpreßkraft auf das Leistungsbauelement 16 erreicht wird. Der Elastomerstreifen 61 kann hierbei an der Innenseite des Gehäusedeckels 18 angeklebt werden, so daß er nach dem Zusammenbau des Steuergeräts etwa mittig auf den Leistungsbauelementen 16 aufliegt. Der Gehäusedeckel 18d kann dabei auch so geformt werden, wie er in der Figur 8 dargestellt wird, daß er zwei Wannen aufweist, so daß in deren Bereich auch Leistungsbauelemente mit größerer Bauhöhe angeordnet werden können.

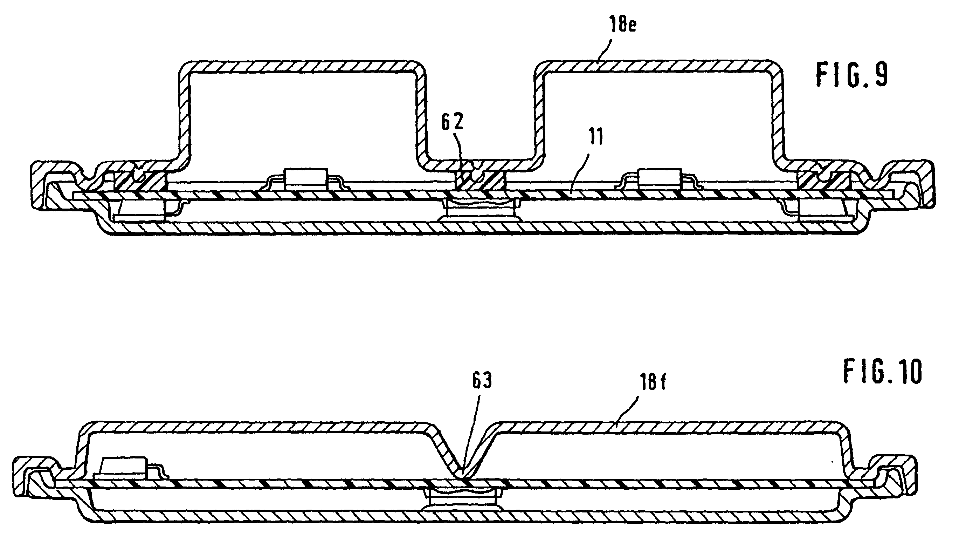

Beim Ausführungsbeispiel nach der Figur 9 ist als Federelement ein elastisches Kunststoffteil 62 zwischen dem Gehäusedeckel 18d und der Leiterplatte 11 eingespannt. Das Kunststoffteil 62 kann zum Beispiel zur Fixierung eine Ausnehmung oder eine Längsnut aufweisen, in die ein am Gehäusedeckel 18e angebrachter Noppen eingreift.

Auch der Gehäusedeckel 18f kann so ausgebildet sein, daß er aufgrund einer mechanischen Vorspannung eine Anpreßkraft auf das Leistungsbauelement 16 ausübt. Wie in der Figur 10 dargestellt ist, ist dann im Gehäusedeckel im Bereich des Leistungsbauelements 16 zum Beispiel eine Sicke ausgebildet, mit der der Gehäusedeckel auf die Leiterplatte 11 und somit auf das Leistungsbauelement 16 drückt.

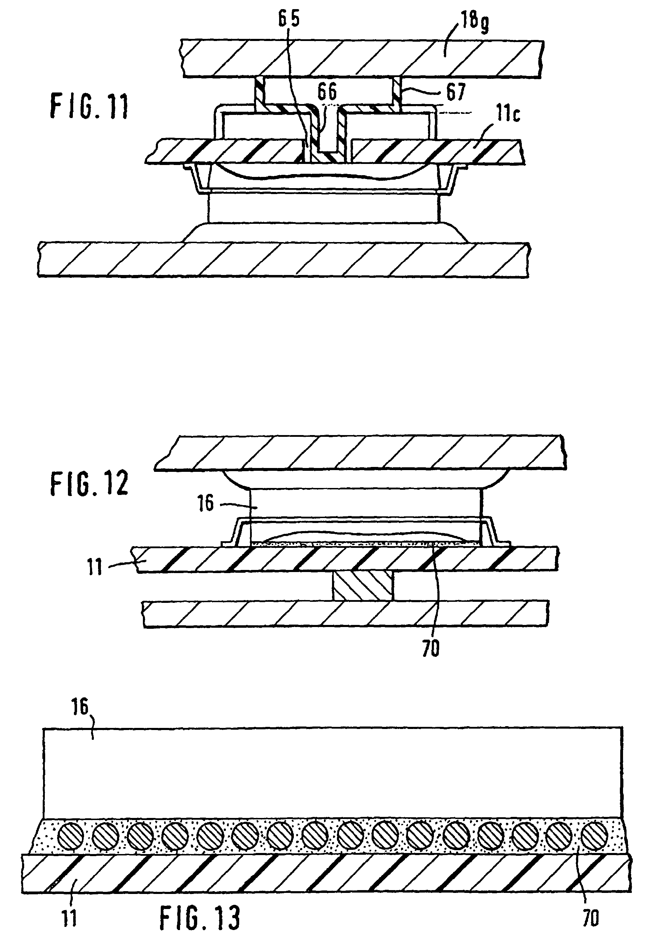

Bei den Ausführungsbeispielen nach den Figuren 7 bis 10 hat das jeweilige Hilfsmittel bzw. das Gehäuseteil die Anpreßkraft nur mittelbar auf das Leistungsbauelement 16, d.h. auf die Leiterplatte 11 und dann auf das Leistungsbauelement 16 ausgeübt. In der Figur 11 ist nun ein Ausführungsbeispiel dargestellt, bei dem die Anpreßkraft direkt auf das Leistungsbauelement 16 ausgeübt wird. Hierzu weist die Leiterplatte 11c eine Ausnehmung 65 auf, in die ein Fortsatz 66 einer Klammer 67 greift. Die Klammer 67 liegt andererseits an der Innenseite des Gehäusedeckels 18g an. Die Klammer 67 kann hierbei aus elastischem Kunststoff hergestellt sein.

Bei der Abwandlung nach der Figur 12 wird zur Erhöhung der Zuverlässigkeit zwischen dem Leistungsbauelement 16 und der Leiterplatte 11 ein Kapillarkleber 70 eingebracht. Somit wird der zwischen dem Leistungsbauelement 16 und der Leiterplatte 11 vorhandene Hohlraum durch den Kapillarkleber 70 ausgefüllt. Der Kapillarkleber 70 kann hierbei, wie in der Figur 12 ersichtlich, auch den Bereich unter den Anschlüssen des Leistungsbauelements 16 oder anderen Kontaktierungen z.B. BGA (Ball Grid Array) und auch den Bereich um die Ball Grid Array's (BGA's) ausfüllen. Das Leistungsbauelement 16 und gegebenenfalls auch die Kontaktierungen bzw. die Anschlüsse erfahren dadurch weniger Belastung, die durch die Elastizität des Gehäuses, der Temperatureinflüsse, der Biegebeanspruchungen und der unterschiedlichen Ausdehnungskoeffizienten zwischen dem Substrat der Leiterplatte und dem Leistungsbauelement hervorgerufen werden. In der Figur 13 ist als weitere Ausbildung im Detail und vergrößert der unter einem Leistungsbauelement 16 angebrachte Kapillarkleber 70, falls Ball Grid Array's (BGA's) vorhanden sind, dargestellt.

## Patentansprüche

1. Steuergerät (10) bestehend aus mindestens zwei Gehäuseteilen (18, 26) und mindestens einer Leiterplatte (11),
- wobei ein erstes der Gehäuseteile (18, 26) einen Kühlkörper bildet,
- wobei die Leiterplatte (11) auf mindestens einer Seite ((12, 13) mit Leistungsbauelementen (15, 16) bestückt ist,
- wobei das als Kühlkörper dienende Gehäuseteil (18, 26) mit einer Innenseite auf einer der Leiterplatte (11) abgewandten Seite (31) mindestens eines der Leistungsbauelemente anliegt,
- wobei zwischen dem mindestens einen zu kühlenden Leistungsbauelement (15, 16) und einem zweiten Gehäuseteil (18, 26) ein mechanisches Hilfsmittel (60, 61, 62, 66) vorhanden ist, so dass eine gleichmäßige Auflage des Leistungsbauelements (16), auf dem als Kühlkörper dienenden Gehäuseteil (18, 26) ermöglicht ist,
- wobei die Leistungsbauelemente (15, 16) auf der Leiterplatte (11) frei platzierbar sind.

2. Steuergerät nach Anspruch 1 oder 2, **dadurch gekennzeichnet, dass** das mechanische Hilfsmittel eine Anpresskraft auf die Leiterplatte (11) und so auf das Leistungsbauelement (15, 16) ausübt.

3. Steuergerät nach Anspruch 1 oder 2, **dadurch gekennzeichnet, dass** das mechanische Hilfsmittel die Anpresskraft durch eine Ausnehmung (65) in der Leiterplatte (11) hindurch direkt auf das Leistungsbauelement (15, 16) ausübt.

4. Steuergerät nach einem der vorhergehenden Ansprüche, **dadurch gekennzeichnet, dass** das Gehäuseteil (18, 26) flächig auf dem mindestens einen Leistungsbauelement (16) aufliegt.

5. Steuergerät nach einem der vorhergehenden Ansprüche, **dadurch gekennzeichnet, dass** die Ober- (12) und die Unterseite (13) der Leiterplatte (11) mit Leistungsbauelementen (15, 16) bestückt ist.

6. Steuergerät nach einem der vorhergehenden Ansprüche, **dadurch gekennzeichnet, dass** die Leistungsbauelemente (15, 16) an dem als Kühlkörper dienenden Gehäuseteil (18, 26) mittels eines wärmeleitenden Klebers angeklebt sind.

7. Steuergerät nach einem der vorhergehenden Ansprüche, **dadurch gekennzeichnet, dass** auf dem als Kühlkörper dienenden Gehäuseteil (18, 26) mindestens ein wärmeleitender Körper (52, 54, 56) angeordnet ist.

8. Steuergerät nach Anspruch 8, **dadurch gekennzeichnet, dass** der wärmeleitende Körper (52) eine Wärmesenke darstellt.

9. Steuergerät nach Anspruch 8, **dadurch gekennzeichnet, dass** das wärmeleitende Gehäuseteil (18) mindestens ein Befestigungsteil (54) für das Steuergerät ist.

10. Steuergerät nach Anspruch 8, **dadurch gekennzeichnet, dass** das wärmeleitende Gehäuseteil (18) Kühlrippen (56) aufweist.

11. Steuergerät nach einem der vorhergehenden Ansprüche, **dadurch gekennzeichnet, dass** sich zwischen dem Leistungsbauelement (16) und der Leiterplatte (11) ein Kapillarkleber (70) befindet.

12. Steuergerät (10) bestehend aus mindestens zwei Gehäuseteilen (18, 26) und mindestens einer Leiterplatte (11), die mit Leistungsbauelementen (15, 16) bestückt ist,
- wobei beide Gehäuseteile (18, 26) jeweils einen Kühlkörper bilden,
- wobei auf jeder der beiden Seiten (12, 13) der Leiterplatte (11) jeweils mindestens ein Leistungsbauelement (15, 16) angeordnet ist,
- wobei die als Kühlkörper dienenden Gehäuseteile (18, 26) jeweils mit einer Innenseite auf einer der Leiterplatte (11) abgewandten Seite (31) mindestens eines der Leistungsbauelemente (15, 16) auf jeweils einer Seite (12, 13) der Leiterplatte (11) anliegt,
- wobei die Leistungsbauelemente (15, 16) an dem als Kühlkörper dienenden Gehäuseteil (18, 26) mittels eines wärmeleitenden Klebers angeklebt sind,
- wobei die Leistungsbauelemente (15, 16) auf der Leiterplatte (11) frei platzierbar sind.

## Claims

1. Control device (10) comprising at least two housing parts (18, 26) and at least one printed circuit board (11),
- in which a first one of the housing parts (18, 26) forms a cooling member,
- in which the printed circuit board (11) is fitted on at least one side (12, 13) with power components (15, 16) ,
- in which the housing part (18, 26) serving as cooling member bears with an inner side against a side (31), averted from the printed circuit board (11), of at least one of the power components,
- in which a mechanical aid (60, 61, 62, 66) is present between the at least one power component (15, 16) to be cooled and a second housing part (18, 26) so as to permit the power component (16) to be supported uniformly on the housing part (18, 26) serving as cooling member, and
- in which the power components (15, 16) can be placed freely on the printed circuit board (11).

2. Control device according to Claim 1 or 2, **characterized in that** the mechanical aid exerts a contact force on the printed circuit board (11) and thus on the power component (15, 16).

3. Control device according to Claim 1 or 2, **characterized in that** the mechanical aid exerts the contact force directly onto the power component (15, 16) through a cutout (65) in the printed circuit board (11).

4. Control device according to one of the preceding claims, **characterized in that** the housing part (18, 26) is supported in a planar fashion on the at least one power component (16).

5. Control device according to one of the preceding claims, **characterized in that** the top side (12) and the underside (13) of the printed circuit board (11) are fitted with power elements (15, 16).

6. Control device according to one of the preceding claims, **characterized in that** the power components (15, 16) are bonded on the housing part (18, 26) serving as cooling member by means of a thermally conducting adhesive.

7. Control device according to one of the preceding claims, **characterized in that** at least one thermally conducting body (52, 54, 56) is arranged on the housing part (18, 26) serving as cooling member.

8. Control device according to Claim 8, **characterized in that** the thermally conducting body (52) constitutes a heat sink.

9. Control device according to Claim 8, **characterized in that** the thermally conducting housing part (18) is at least a fastening part (54) for the control device.

10. Control device according to Claim 8, **characterized in that** the thermally conducting housing part (18) has cooling ribs (56).

11. Control device according to one of the preceding claims, **characterized in that** a capillary adhesive (70) is located between the power component (16) and the printed circuit board (11).

12. Control device (10) comprising at least two housing parts (18, 26) and at least one printed circuit board (11), which is fitted with power components (15, 16),
- in which the two housing parts (18, 26) each form a cooling member,
- in which in each case at least one power component (15, 16) is arranged on each of the two sides (12, 13) of the printed circuit board (11),
- in which the housing parts (18, 26) serving as cooling members bear in each case with an inner side against a side (31), averted from the printed circuit board (11), of at least one of the power components (15, 16) on in each case one side (12, 13) of the printed circuit board (11),
- in which the power components (15, 16) are bonded on the housing part (18, 26) serving as cooling member by means of a thermally conducting adhesive, and
- in which the power components (15, 16) can be placed freely on the printed circuit board (11).

## Revendications

1. Appareil de commande (10) composé d'au moins deux pièces de boîtier (18, 26) et d'au moins une plaquette de circuits imprimés (11), dans lequel
- une première pièce de boîtier (18, 26) forme un refroidisseur,
- la plaquette de circuits imprimés (11) est équipée, sur au moins une face (12, 13), de composants de puissance (15, 16),
- la pièce de boîtier (18, 26) servant de refroidisseur a une face interne qui repose sur une face d'au moins un des composants de puissance opposée (31) à la plaquette de circuits imprimés (11),
- entre au moins l'un des composants de puissance (15, 16) à refroidir et une deuxième pièce de boîtier (18, 26), un accessoire mécanique (60, 61, 62, 66), est monté de façon à pouvoir placer de manière uniforme le composant de puissance (16) sur la pièce de boîtier (18, 26) servant de refroidisseur, et
- les composants de puissance (15, 16) peuvent être librement placés sur la plaquette de circuits imprimés (11).

2. Appareil de commande selon la revendication 1 ou 2,
**caractérisé en ce que**
l'accessoire mécanique exerce une force de pression sur la plaquette de circuits imprimés (11) et sur le composant de puissance (15, 16).

3. Appareil de commande selon la revendication 1 ou 2,
**caractérisé en ce que**
l'accessoire mécanique exerce la force de pression grâce à un logement (65) dans la plaquette de circuits imprimés (11) permettant de communiquer directement avec le composant de puissance (15, 16).

4. Appareil de commande selon l'une quelconque des revendications précédentes,
**caractérisé en ce que**
la pièce de boîtier (18, 26) repose en surface sur au moins l'un des composants de puissance (16).

5. Appareil de commande selon l'une quelconque des revendications précédentes,
**caractérisé en ce que**
la face supérieure (12) et la face inférieure (13) de la plaquette de circuits imprimés (11) est équipée de composants de puissance (15, 16).

6. Appareil de commande selon l'une quelconque des revendications précédentes,
**caractérisé en ce que**
les composants de puissance (15, 16) sont collés sur la pièce de boîtier (18, 26) servant de refroidisseur à l'aide d'une colle conductrice de chaleur.

7. Appareil de commande selon l'une quelconque des revendications précédentes,
**caractérisé en ce qu'**
au moins un corps conducteur de chaleur (52, 54, 56) est placé sur la pièce de boîtier (18, 26) servant de refroidisseur.

8. Appareil de commande selon la revendication 8,
**caractérisé en ce que**
le corps conducteur de chaleur (52) représente un puits de chaleur.

9. Appareil de commande selon la revendication 8,
**caractérisé en ce que**
la pièce de boîtier (18) conductrice de chaleur constitue au moins une pièce de fixation (54) pour l'appareil de commande.

10. Appareil de commande selon la revendication 8,
**caractérisé en ce que**
la pièce de boîtier (18) conductrice de chaleur présente des ailettes de refroidissement (56).

11. Appareil de commande selon l'une quelconque des revendications précédentes,
**caractérisé en ce qu'**
un dispositif de collage par capillarité (70) est placé entre le composant de puissance (16) et la plaquette de circuits imprimés (11).

12. Appareil de commande (10) composé d'au moins deux pièces de boîtier (18, 26) et d'au moins une plaquette de circuits imprimés (11), équipée de composants de puissance (15, 16), dans lequel
- les deux pièces de boîtier (18, 26) forment un refroidisseur,
- au moins un composant de puissance (15, 16) est respectivement placé sur chacune des deux faces (12, 13) de la plaquette de circuits imprimés (11),
- les pièces de boîtier (18, 26) servant de refroidisseur ont chacune une face interne qui repose sur une face (31) opposée à la plaquette de circuits imprimés (11) d'au moins un des composants de puissance (15, 16) sur chaque face (12, 13) de la plaquette de circuits imprimés (11).
- les composants de puissance (15, 16) sont collés à la pièce de boîtier (18, 26) servant de refroidisseur à l'aide d'une colle conductrice de chaleur, et
- les composants de puissance (15, 16) peuvent être librement placés sur la plaquette de circuits imprimés (11).
